# EUROPEAN PATENT SPECIFICATION

(11) **EP 2 400 544 B1**
(45) Date of publication and mention of the grant of the patent: **06.05.2020**
(21) Application number: 11002884.2
(22) Date of filing: 06.04.2011
(51) Int. Cl.: H01L 23/40

(54) **Fixture for assembling heat generating component and radiating component and heat sink assembly using the same**
Vorrichtung zur Montage einer wärmeerzeugenden Komponente und Abstrahlkomponente sowie Kühlkörperanordnung damit
Mecanisme permettant d'assembler un composant de génération de chaleur et composant de rayonnement et ensemble de dissipateur de chaleur l'utilisant

(30) Priority: 25.06.2010 JP 2010144788
(43) Date of publication of application: 28.12.2011
(73) Proprietor: Mitsubishi Electric Corporation, Tokyo 100-8310 (JP)
(72) Inventor: Asayama, Shinji, Tokyo 100-8310 (JP)
(74) Representative: Pfenning, Meinig & Partner mbB

(56) References cited:
- US-A- 5 371 652
- US-A- 5 430 610
- US-A- 5 678 627
- US-A- 5 771 155
- US-A1- 2005 013 120
- US-A1- 2005 263 264
- US-A1- 2009 147 475
- US-B1- 6 532 746

## Description

### BACKGROUND OF THE INVENTION

### Field of the Invention

The present invention relates to a fixture for assembling that can bring a high heat generating component and a radiating component into contact with each other and fix them easily with a predetermined pressing pressure when the radiating component such as a heat sink is used for cooling the high heat generating component of an electronic device such as a lead-type package IC.

### Description of the Related Art

Hitherto, a radiating component such as a heat sink is used for cooling a high heat generating component of an electronic device. Fixation of the heat generating component and the radiating component is performed by tightening a screw with a predetermined torque in general. Also, the one fixing the heat generating component and the radiating component using a leaf spring or a wire spring and a retainer (See Patent Literatures 1, for example) or the one fixing the heat generating component and the radiating component by giving a spring pressure using a torsion spring and a bracket at the same time are known (See Patent Literatures 2, for example).

### CITATION LIST

### Patent Literature

Patent Literature 1 Japanese Unexamined Patent Application Publication No. 7-183679 (Figs. 5 and 9)
Patent Literature 2 Japanese Unexamined Patent Application Publication (Translation of PCT Application) No. 2001-515272 (Fig.1)

US 6,532,746 B1 discloses a securing apparatus that is used to secure an electronic component, such as a thermoelectric cooler in a thermoelectric cooling system. The securing apparatus includes a clamping mechanism that clamps the electronic component between a first plate, such as a heat sink plate, and a second plate, such as a mounting plate. The clamping mechanism applies compression forces to the electronic component to secure the electronic component without using shear forces capable of damaging the electronic component. The clamping mechanism preferably provides thermal isolation between the heat sink plate and the mounting plate.

US 5,430,610 A discloses a positioning device for a heat sink on computer chips (CPU) which includes a seat placed on the CPU for mounting a fan and has a fixed clamping member on one end for hooking onto a shoulder of the CPU and a movable clamping member for hooking another shoulder of the CPU. An elastic element is disposed between the seat and the movable clamping member to hook the CPU by the restoring force thereof and which has two ends extending to both sides of the seat which are folded down to abut both ends of the CPU opposite to each other.

US 5,771,155 A discloses a spring clamp device providing a compressive stress to a stack of components which includes a spring member and a bracket having the attachment structure for engaging mating structure near the bottom of the stack. The bracket is first engaged with the mating structure such that it straddles the stack. The spring member is then latched to the bracket under tension in an assembled configuration, thereby applying an upward reaction of the mating structure with the attachment structure of the bracket and applying a downward reaction force to the top of the stack with the spring member. The oppositely directed forces apply a compressive stress to the stack, which improves thermal contact between the components.

US 2005/0013120 A1 discloses a heat sink apparatus for use with electronic components, which comprises a base frame, a clipping system and a plurality of supporting members. The base frame and the clipping system and the supporting members are of unitary construction. The base frame is configured to have "i" repeatable channels with fins extended from or attached to its outside surfaces. The clipping system comprises a matrix [i,j] set of ixj spring clips. Each spring clip is configured to have partially constrained with the base frame, and to flex about an axis resiliently to effect an engaged relation to substantially fixedly maintain the electronic component in abutting relation with the inside walls of the channel. The supporting members are configured to have fixed connection with the base frame and be solderable. The heat sink apparatus's capacity of holding electronic components is scalable to accommodate upgrades and design changes of electronic products.

### SUMMARY OF THE INVENTION

### Technical Problem

In the case of the method of fixing the heat generating component and the radiating component using a screw, the pressing pressure for the heat generating component and the radiating component is obtained by giving an appropriate tightening torque to the screw. However, in this case, the tightening torque needs to be managed, and also, a difference occurs in the applied pressing pressures between a peripheral portion of the screw and the other portions.
Moreover, it is difficult to check the tightening torque after assembling.

On the other hand, in the case of the method using the leaf spring or the wire spring, adjustment of the pressing pressure of the spring is difficult. Moreover, in any of the spring methods including the fixing method using the torsion spring, a fixing spot for the spring is formed by using a retainer or a bracket, which are originally separate components, at the same time, which increases the number of components and complicates the configuration.

A technical object of the present invention is to enable fixation of the heat generating component and the radiating component with a simple structure without requiring another component such as a retainer or a bracket for fixing the spring.

### Solution to Problem

This problem is solved by the fixture of claim 1 and the heat sink of claim 2. A fixture for assembling a heat generating component and a radiating component according to the present invention is a fixture for assembling that is formed from a single wire material and fixes the heat generating component and the radiating component and has at least two spiral portions that are formed in the middle of the wire material and generate a torsion torque giving pressing pressures to the heat generating component and the radiating component, a first fixing portion that is formed between the spiral portions of the wire material and fixes the heat generating component or the radiating component, and second fixing portions that are formed at both ends of the wire material, respectively, and fix the heat generating component or the radiating component, so as to bring the heat generating component and the radiating component into contact with each other by a predetermined pressing pressure through the torsion torque of the spiral portions and fix them.

### Advantageous Effect of Invention

The fixture for assembling the heat generating component and the radiating component of the present invention is configured such that the torsion torque of the spiral portion called a torsion spring in general is given as the pressing pressures of the heat generating component and the radiating component, and thus, by changing each of the elements such as a coiling diameter, a coiling number and a torsion angle of the spiral portion, a predetermined pressing pressure can be obtained, and a movable region can be taken large compared to a leaf spring or a usual wire spring. Thus, adjustment of the pressing pressure of the spring is easy, whereby the pressing pressure can be made stable.

Also, since at least two spiral portions that generate the torsion torque, the first fixing portion that is formed between the spiral portions of the wire material and fixes the heat generating component or the radiating component, and the second fixing portions (two spots) that are formed at both ends of the wire material, respectively, and fix the heat generating component or the radiating component are provided in the structure formed from the single wire material so that the heat generating component and the radiating component are brought into contact with each other by the predetermined pressing pressures by the torsion torque of the spiral portions and fixed at least at three spots, the target heat generating component and radiating component can be reliably fixed only by one component and portions to which the pressing pressure by the torsion torque is applied can be set at positions suitable for radiation or fixation. Thus, heat generation of the heat generating component can be efficiently radiated, and also, loss by heat in the heat generating component can be reduced.

### BRIEF DESCRIPTION OF THE DRAWINGS

Fig. 1 is a perspective view illustrating a state of a fixture for assembling a heat generating component and a radiating component before mounting according to Embodiment 1 of the present invention;
Fig. 2 is a perspective view illustrating a state of the fixture for assembling the heat generating component and the radiating component in the middle of mounting and a state of a heat sink assembly in the middle of assembling according to Embodiment 1 of the present invention;
Fig. 3 is a perspective view illustrating a state of the fixture for assembling the heat generating component and the radiating component after mounting and a state of the heat sink assembly after assembling according to Embodiment 1 of the present invention;
Fig. 4 is a perspective view illustrating a state of a fixture for assembling the heat generating component and the radiating component after mounting and a state of the heat sink assembly after assembling according to Embodiment 2 of the present invention;
Fig. 5 is a perspective view illustrating a state of a fixture for assembling the heat generating component and the radiating component after mounting and a state of the heat sink assembly after assembling according to Embodiment 3 of the present invention;
Fig. 6 is a perspective view illustrating a state of a fixture for assembling the heat generating component and the radiating component after mounting and a state of the heat sink assembly after assembling according to Embodiment 4 of the present invention;
Fig. 7 is a perspective view illustrating a state of a fixture for assembling a heat generating component and a radiating component after mounting and a state of a heat sink assembly after assembling according to Embodiment 5 of the present invention; and
Fig. 8 is a perspective view illustrating a state of a fixture for assembling a heat generating component and a radiating component after mounting and a state of a heat sink assembly after assembling according to Embodiment 6 of the present invention.

### DESCRIPTION OF THE PREFERRED EMBODIMENTS

### Embodiment 1.

The present invention will be described below referring to illustrated Embodiments.

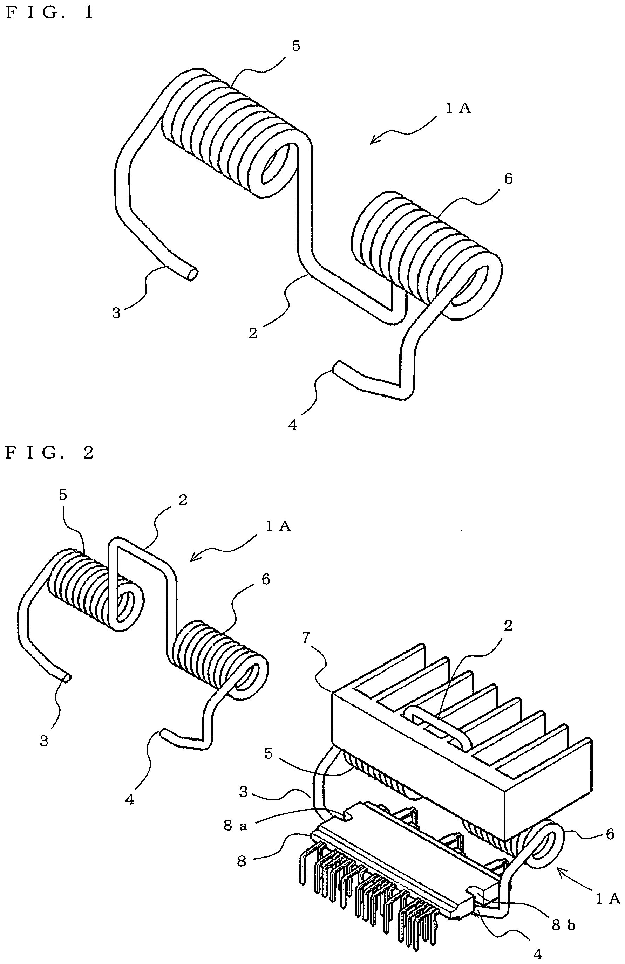

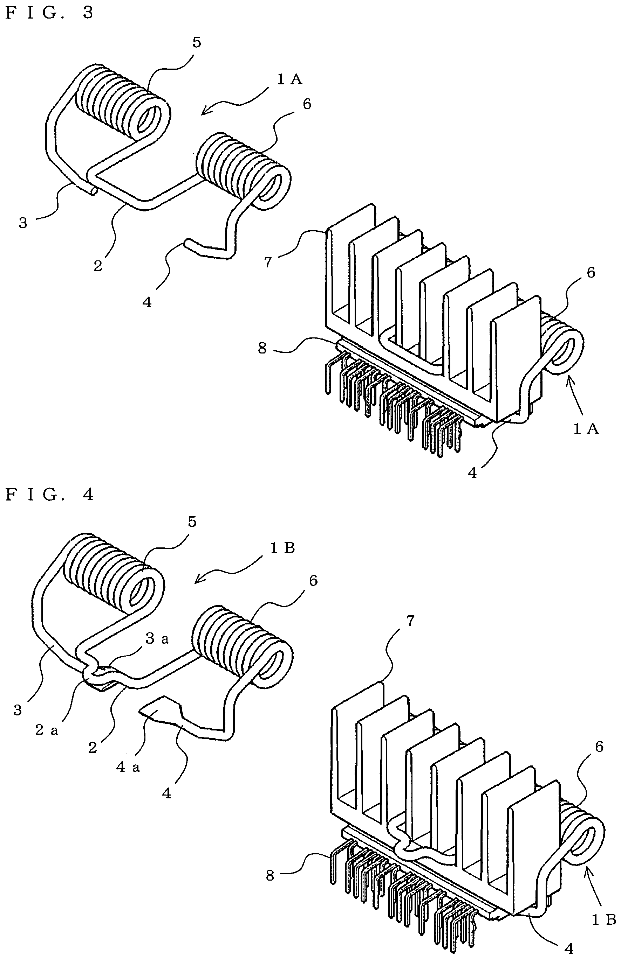

Fig. 1 is a perspective view illustrating a state of a fixture for assembling a heat generating component and a radiating component before mounting (a state in which a torsion torque has not been generated) according to Embodiment 1 of the present invention, Fig. 2 is a perspective view illustrating a state of the fixture for assembling the heat generating component and the radiating component in the middle of mounting (a state in which a spring is opened) and a state of a heat sink assembly in the middle of assembling, and Fig. 3 is a perspective view illustrating a state of the fixture for assembling the heat generating component and the radiating component after mounting (a state in which the spring is closed and a predetermined torsion torque has been generated) and a state of the heat sink assembly after assembling.

As for the fixture for assembling the heat generating component and the radiating component of this embodiment, a torsion spring component 1A, which is the fixture for assembling as shown in Fig. 1, is formed from a single wire material. That is, the torsion spring component 1A has two spiral portions 5 and 6 that generate the torsion torque in the middle of the wire material. A first fixing portion 2 shaped in the U-shape in compliance with the shape of a heat sink 7, which is a radiating component, is formed between these spiral portions 5 and 6. Therefore, by twisting the spiral portions 5 and 6, the heat sink 7 is fixed by the first fixing portion 2 and also a pressing pressure can be given thereto.

Also, at both ends of the wire material of the torsion spring component 1A, second fixing portions 3 and 4 shaped in compliance with the shape of a lead-type package IC 8 are formed so as to be able to fix the lead-type package IC 8, which is the heat generating component, and to give the pressing pressure thereto. Relative positions of the first fixing portion 2 and the second fixing portions 3 and 4 are set at positions which give a predetermined torsion angle to the spiral portions 5 and 6 in advance so as to generate a required torsion torque in a tangential direction of a circle centering on the spiral portions 5 and 6 so that the predetermined pressing pressure can be generated between the lead-type package IC 8 and the heat sink 7 after assembling.

Subsequently, an assembling procedure of a heat sink assembly will be described referring to Figs. 1 to 3.

First, in a state in which the second fixing portions 3 and 4 of the torsion spring component 1A to mount on the lead-type package IC 8 are fixed, the first fixing portion 2 to mount the heat sink 7 is moved upward by giving a force in a rotating direction (twisting direction) of the spiral portions 5 and 6. As a result, as shown in Fig. 2, the relative positional relationship between the second fixing portions 3 and 4 and the first fixing portion 2 can be changed. At this time, since the torsion torque is generated in the rotating direction of the spiral portions 5 and 6, in order to maintain the state in Fig. 2, a state that the force is applied to the first fixing portion 2 or a state that it fixes is kept.

Next, in the state that this spring is opened (state in Fig. 2), the heat sink 7, which is the radiating component, is mounted on the first fixing portion 2. On the other hand, the lead-type package IC 8, which is the heat generating component, is mounted on the second fixing portions 3 and 4. At this time, distal ends of the second fixing portions 3 and 4 are set to be overlapped with positions of notches 8a and 8b formed in a body of the lead-type package IC 8.

Then, the force having been applied to the first fixing portion 2 is relaxed or the fixed state is released so that the first fixing portion 2 and the heat sink 7 mounted thereon are moved along the rotating direction of the spiral portions 5 and 6 by the torsion torque of the spiral portions 5 ant 6. As a result, the torsion spring component 1A is brought into a state in Fig. 3, and a heat generating surface of the lead-type package IC 8 is combined (overlapped) and fixed in a state in contact with the heat sink 7.

In the state in Fig. 3, since the first fixing portion 2 is located at a position having been moved in the twisting direction of the spiral portions 5 and 6 from the state before mounting in Fig. 1 (the state in which no torsion torque has been generated yet), a force for the torsion spring component 1A to return to the state before mounting, that is, a torsion torque in the counter-rotating direction is generated in the torsion spring component 1A. As a result, a force is applied to the first fixing portion 2 downward in Fig. 3 in the tangential direction of the circle centering on the spiral portions 5 and 6 and a force is applied to the second fixing portions 3 and 4 upward in Fig. 3 in the tangent of the circle centering on the spiral portions 5 and 6. Then, a pressing pressure is continuously given to the contact surface between the heat sink 7 mounted on the first fixing portion 2 and the lead-type package IC 8 mounted on the second fixing portions 3 and 4 in Fig. 3.

As described above, in this embodiment, the lead-type package IC 8, which is the heat generating component, and the heat sink 7, which is the radiating component, can be assembled without using a component other than the torsion spring component 1A. Also, since the torsion torque of the two spiral portions 5 and 6 acts between the first fixing portion 2 and the second fixing portion 3 as well as between the first fixing portion 2 and the second fixing portion 4, respectively, the three points maintain a stable positional state, and the pressing pressure required for each of the spots can be given. Thus, heat generation of the heat generating component can be efficiently radiated, damage by the heat in the heat generating component can be reduced, and thus, reliability of the heat sink assembly using this torsion spring component 1A (fixture for assembling) can be improved.

### Embodiment 2.

Fig. 4 is a perspective view illustrating a state of a fixture for assembling the heat generating component and the radiating component after mounting (a state in which a spring is closed and a predetermined torsion torque is generated) and a state of the heat sink assembly after assembling according to Embodiment 2 of the present invention. The same reference numerals are given to the same portions as those in the above-described Embodiment 1, and the description will be omitted.

The fixture for assembling the heat generating component and the radiating component of this embodiment has a structure in which distal ends of the second fixing portions 3 and 4 of a torsion spring component 1B, which is the fixture for assembling, to mount the lead-type package IC 8 are formed as flat portions 3a and 4a, respectively, as shown in Fig. 4 so that a pressing pressure acting on the lead-type package IC 8 is distributed by the flat portions 3a and 4a and is supported by a wider area. Also, the first fixing portion 2 of the torsion spring component 1B to mount the heat sink 7 has a structure in which a projection portion 2a to become a holding portion during an operation is disposed in order to facilitate an opening/closing operation of the torsion spring component 1B during assembling. The other configurations are similar to those in the above-described Embodiment 1.

In this embodiment, since the pressure applied to the lead-type package IC 8 can be distributed by the flat portions 3a and 4a at the distal ends of the second fixing portions 3 and 4 of the torsion spring component 1B, a mechanical load to the lead-type package IC 8 can be alleviated. Eventually, reliability of the heat sink assembly using this torsion spring component 1B (fixture for assembling) can be improved.

Also, since the projection portion 2a is disposed on the first fixing portion 2 on which the heat sink 7 of the torsion spring component 1B is mounted, the opening/closing operation of the torsion spring component 1B becomes facilitated, and assembling workability is improved.

### Embodiment 3.

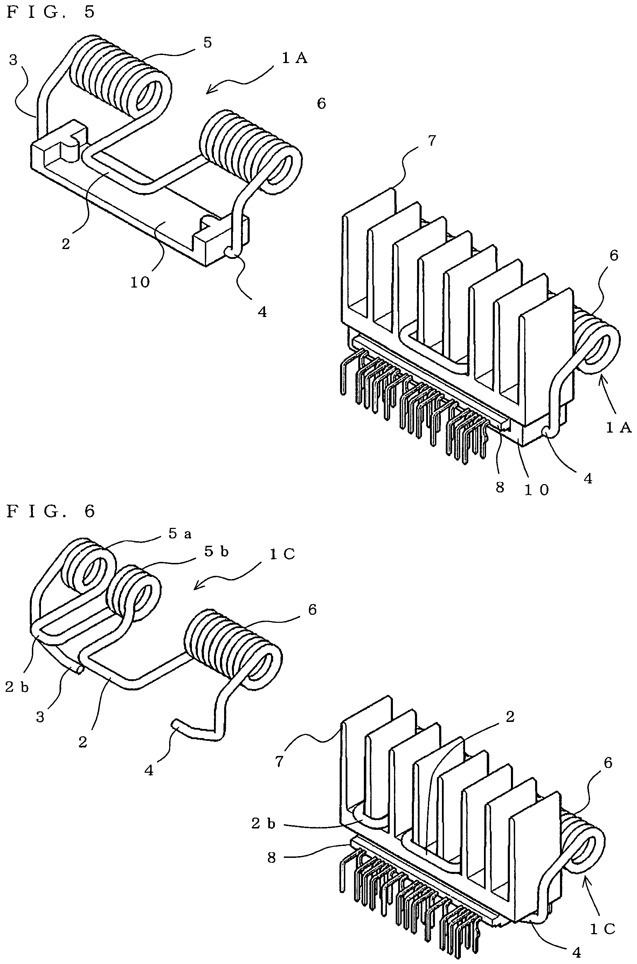

Fig. 5 is a perspective view illustrating a state of a fixture for assembling the heat generating component and the radiating component after mounting (a state in which a spring is closed and a predetermined torsion torque is generated) and a state of the heat sink assembly after assembling according to Embodiment 3 of the present invention. In the figure, the same reference numerals are given to the same portions as those in the above-described Embodiment 1, and the description will be omitted.

The fixture for assembling the heat generating component and the radiating component of this embodiment is configured such that a heat generating component positioning member 10 to become a base of the lead-type package IC 8 is mounted on the second fixing portions 3 and 4 of the torsion spring component 1A, which is the fixture for assembling, to mount the lead-type package IC 8 as shown in Fig. 5 so that a position of the lead-type package IC 8 is set by the heat generating component positioning member 10 and the pressing pressures of the second fixing portions 3 and 4 are given to the lead-type package IC 8 through the heat generating component positioning member 10. The other configurations are similar to those in the above-described Embodiment 1.

In this embodiment, since the pressing pressures of the second fixing portions 3 and 4 are given to the lead-type package IC 8 through the heat generating component positioning member 10, a mechanical load to the lead-type package IC 8 can be further alleviated. Thus, reliability of the heat sink assembly using this torsion spring component 1A (fixture for assembling) can be further improved.

### Embodiment 4.

Fig. 6 is a perspective view illustrating a state of a fixture for assembling the heat generating component and the radiating component after mounting (a state in which a spring is closed and a predetermined torsion torque is generated) and the state of the heat sink assembly after assembling according to Embodiment 4 of the present invention. The same reference numerals are given to the same portions as those in the above-described Embodiment 1, and the description will be omitted.

In the fixture for assembling the heat generating component and the radiating component of this embodiment, the one spiral portion 5 out of the two spiral portions 5 and 6 of a torsion spring component 1C, which is a fixture for assembling is further divided into two spiral portions 5a and 5b as shown in Fig. 6. A first fixing portion 2b is newly added between them so as to have a structure having three spiral portions 6, 5a, and 5b that generate a torsion torque and two first fixing portions 2 and 2b that fix the heat sink 7, which is the radiating component. The other configurations are similar to those in the above-described Embodiment 1.

In this embodiment, the asymmetric pressing pressures can be applied to the lead-type package IC 8, which is the heat generating component, and the heat sink 7, which is the radiating component. Therefore, by adding the first fixing portion 2b according to a specific portion for which a cooling effect is to be raised, the cooling effect of the specific portion can be raised. Thus, reliability of the heat sink assembly using this torsion spring component 1C (fixture for assembling) can be improved.

### Embodiment 5.

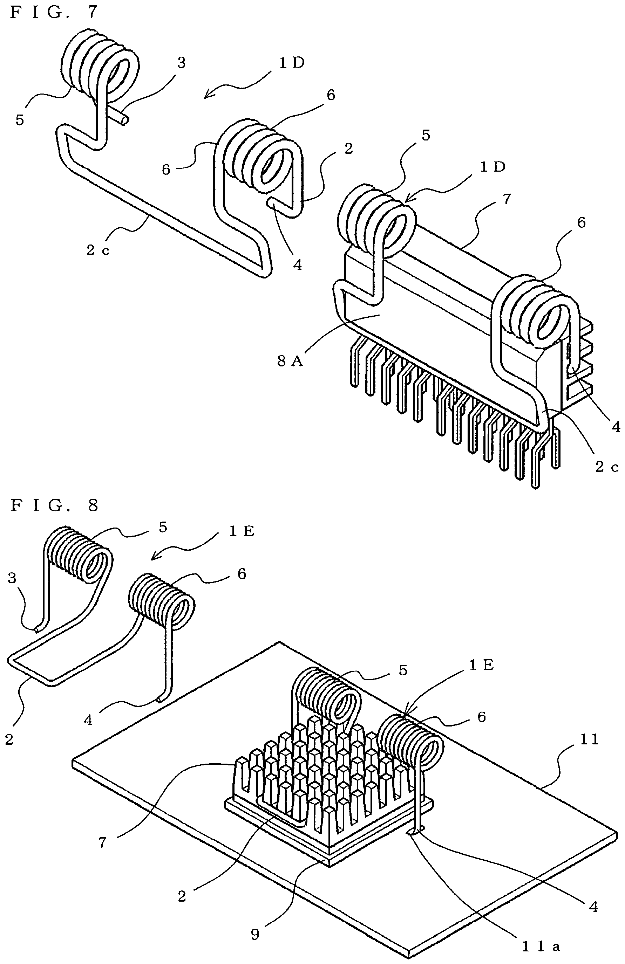

Fig. 7 is a perspective view illustrating a state of a fixture for assembling the heat generating component and the radiating component after mounting (a state in which a spring is closed and a predetermined torsion torque is generated) and a state of a heat sink assembly after assembling according to Embodiment 5 of the present invention. In the figure, the same reference numerals are given to the same portions as those in the above-described Embodiment 1, and the description will be omitted.

The fixture for assembling the heat generating component and the radiating component of this embodiment is obtained by applying a torsion spring component 1D, which is the fixture for assembling, to a vertical lead-type package IC 8A, which is the heat generating component, as shown in Fig. 7. That is, between the spiral portions 5 and 6 of the torsion spring component 1D, a wide first fixing portion 2c holding the vertical lead type package IC 8A, which is the heat generating component, is formed. Thus, second fixing portions 3 and 4 that hold the heat sink 7, which is the radiating component, is formed at both ends of the torsion spring component 1D. The other configurations are similar to those in the above-described Embodiment 1.

In this embodiment, by twisting the torsion spring component 1D in the rotating direction (twisting direction) of the spiral portions 5 and 6, the torsion torque can be generated, and the required pressing pressure can be given to the vertical lead-type package IC 8A and the heat sink 7. Thus, heat generation of the heat generating component can be efficiently radiated, damage by heat in the heat generating component can be reduced. Also, reliability of the heat sink assembly using this torsion spring component 1D (fixture for assembling) can be improved.

### Embodiment 6.

Fig. 8 is a perspective view illustrating a state of a fixture for assembling the heat generating component and the radiating component after mounting (a state in which a spring is closed and a predetermined torsion torque is generated) and a state of the heat sink assembly after assembling according to Embodiment 6 of the present invention. The same reference numerals are given to the same functional portions as those in the above-described Embodiment 1, and the description will be omitted.

The fixture for assembling the heat generating component and the radiating component of this embodiment is obtained by applying a torsion spring component 1E, which is the fixture for assembling, to a flat-type package IC 9, which is the heat generating component, as shown in Fig. 8. That is, the torsion spring component 1E is mounted such that the second fixing portions 3 and 4 mounting the flat-type package IC 9 penetrate holes 11a and 11a (only one of them is shown) of a printed circuit board 11, which is a positioning member of the flat-type package IC 9, respectively, and are mounted so as to be engaged with the back face side of the printed circuit board 11 and the pressing pressures of the second fixing portions 3 and 4 are given to the flat-type package IC 9 through the printed circuit board 11. The other configurations are similar to those in the above-described Embodiment 1.

In this embodiment, since the pressing pressures of the second fixing portions 3 and 4 are applied to the flat-type package IC 9 through the printed circuit board 11, which is the heat generating component positioning member, a mechanical load to the flat-type package IC 9 can be alleviated. Thus, reliability of the heat sink assembly using this torsion spring component 1E (fixture for assembling) can be improved.

### Reference Signs List

- 1A, 1B, 1C, 1D, 1E: torsion spring component
- 2, 2b, 2c: first fixing portion
- 2a: projection portion
- 3, 4: second fixing portion
- 3a, 4a: flat portions
- 5, 5a, 5b, 6: spiral portion
- 7: heat sink (radiating component)
- 8: lead-type package IC (heat generating component)
- 9: flat-type package IC (heat generating component)
- 10: heat generating component positioning member
- 11: printed circuit board (heat generating component)

## Claims

1. A fixture for assembling that is formed from a single wire material and fixes a package IC (8) and a heat sink (7), comprising:
at least two spiral portions that are formed in the middle of said wire material and generate a torsion torque to give pressing pressures to said package IC (8) and said heat sink (7);
a first fixing portion (2, 2b, 2c) that is formed between said spiral portions of said wire material and fixes said heat sink (7);
second fixing portions (3, 4) that are formed at both ends of said wire material, respectively, and fix said package IC (8); and
a package IC positioning member (10) capable of being engaged with said second (3, 4) fixing portion, wherein
said package IC (8) is fixed onto said second fixing portion (3, 4) through said positioning member (10); and wherein
said package IC (8) and said heat sink (7) are brought into contact with each other and fixed by a predetermined pressing pressure by the torsion torque of said spiral portion.

2. A heat sink assembly using the fixture for assembling the package IC (8) and the heat sink (7) of claim 1.

## Patentansprüche

1. Fixierungsvorrichtung zum Montieren, die aus einem einzelnen Drahtmaterial gebildet wird und einen Gehäuse-IC (8) (IC - Integrierter Schaltkreis) und einen Kühlkörper (7) fixiert, umfassend:
zumindest zwei Spiralabschnitte, die in der Mitte des Drahtmaterials ausgebildet sind und ein Drillmoment erzeugen, um Pressdruck auf den Gehäuse-IC (8) und den Kühlkörper (7) auszuüben;
einen ersten Fixierungsabschnitt (2, 2b, 2c), der zwischen den Spiralabschnitten des Drahtmaterials ausgebildet ist und den Kühlkörper (7) fixiert;
zweite Fixierungsabschnitte (3, 4), die jeweils an beiden Enden des Drahtmaterials ausgebildet sind und den Gehäuse-IC (8) fixieren; und
ein Gehäuse-IC-Positionierungselement (10), das in der Lage ist, mit dem zweiten (3, 4) Fixierungsabschnitt in Eingriff zu stehen, wobei
der Gehäuse-IC (8) auf dem zweiten Fixierungsabschnitt (3, 4) durch das Positionierungselement (10) fixiert ist; und wobei
der Gehäuse-IC (8) und der Kühlkörper (7) miteinander in Kontakt gebracht und durch einen vorbestimmten Pressdruck durch das Drillmoment des Spiralabschnitts fixiert werden.

2. Kühlkörperanordnung, die die Fixierungsvorrichtung zum Montieren des Gehäuse-ICs (8) und des Kühlkörpers (7) nach Anspruch 1 verwendet.

## Revendications

1. Mécanisme d'assemblage qui est formé à partir d'un seul matériau de fil métallique et fixe un IC (circuit intégré) à boîtier (8) et un dissipateur de chaleur (7), comprenant :
au moins deux parties en spirale qui sont formées au centre dudit matériau en fil métallique et génère un couple de torsion pour donner des pressions de compression audit IC à boîtier (8) et audit dissipateur de chaleur (7) ;
une première partie de fixation (2, 2b, 2c) qui est formée entre lesdites parties en spirale dudit matériau de fil métallique et fixe ledit dissipateur de chaleur (7) ;
des secondes parties de fixation (3, 4) qui sont formées au niveau des extrémités dudit matériau en fil métallique respectivement et fixent ledit IC à boîtier (8) ; et
un élément de positionnement d'IC à boîtier (10) pouvant être mis en prise avec ladite seconde partie de fixation (3, 4), dans lequel :
ledit IC à boîtier (8) est fixé sur ladite seconde partie de fixation (3, 4) par le biais dudit élément de positionnement (10) ; et dans lequel :
ledit IC à boîtier (8) et ledit dissipateur de chaleur (7) sont amenés en contact être eux et fixés par une pression de compression prédéterminée par le couple de torsion de ladite partie en spirale.

2. Ensemble de dissipateur de chaleur utilisant le mécanisme pour assembler l'IC à boîtier (8) et le dissipateur de chaleur (7) selon la revendication 1.
